**Europäisches Patentamt**

**European Patent Office**

**Office européen des brevets**

(19)

(11) Veröffentlichungsnummer: **0 116 922**
**B1**

(12)

# EUROPÄISCHE PATENTSCHRIFT

(45) Veröffentlichungstag der Patentschrift:
**10.12.86**

(21) Anmeldenummer: **84101390.7**

(22) Anmeldetag: **10.02.84**

(51) Int. Cl.⁴: **H 05 K 13/02, B 65 G 47/24**

(54) **Vibrationslängsförderer.**

(30) Priorität: **18.02.83 DE 3305738**

(43) Veröffentlichungstag der Anmeldung:
**29.08.84 Patentblatt 84/35**

(45) Bekanntmachung des Hinweises auf die Patenterteilung:
**10.12.86 Patentblatt 86/50**

(84) Benannte Vertragsstaaten:
**CH DE GB LI**

(56) Entgegenhaltungen:
**DE - A - 3 124 846**

(73) Patentinhaber: **Siemens Aktiengesellschaft Berlin und München, Wittelsbacherplatz 2, D-8000 München 2 (DE)**

(72) Erfinder: **Rohm, Rainer, Dipl.-Ing., Schuchstrasse 16a, D-8000 München 71 (DE)**
Erfinder: **Hilz, Wolfgang, Schulstrasse 43, D-8000 München 19 (DE)**

ACTORUM AG

## Beschreibung

Die Erfindung betrifft einen Vibrationslängsförderer für das Zuführen von Bauelementen nach dem Oberbegriff des Anspruches 1.

Ein derartiger Vibrationslängsförderer für das Zuführen von elektronischen Bauelementen zu einem Bestückautomaten für Leiterplatten oder Keramiksubstrate ist aus der DE-A1-3 124 846 bekannt.

Bei der automatischen Bestückung von Leiterplatten oder Keramiksubstraten mit elektronischen Bauelementen, wie Widerständen, Kondensatoren, Dioden, Transistoren, Chips und dgl. werden aus stranggepressten Profilen bestehende Magazine zunächst in einer Magazin-Fülleinrichtung mit den entsprechenden Bauelementen gefüllt und dann nebeneinander auf dem Rütteltisch eines Vibrationslängsförderers angeordnet. Die in einem Magazin enthaltenen Bauelemente werden durch die Schwingvorrichtung des Rütteltisches zum vorderen Magazinende hin befördert, an welchem durch eine Abflachung bzw. Ausfräsung eine Entnahmeöffnung für die Bauelemente gebildet ist. Die Entnahme der in Abholposition bereitgestellten Bauelemente erfolgt dann jeweils bei Stillstand des Rütteltisches über einen Bestückkopf, welcher das Bauelement mit einer Saugpipette erfasst, mit Hilfe von Hebeln zentriert und auf einer vorbestimmten Stelle der Leiterplatte oder des Keramiksubstrates ablegt. Da von derartigen Bestückautomaten eine Bestückungssicherheit von 99,99% gefordert wird, muss der auf die Koordinaten der Abholpositionen der Magazine programmierte Bestückkopf die Bauelemente dort auch stets in der richtigen Lage antreffen.

Während des Betriebes des Rütteltisches eines Vibrationslängsförderers wirkt auf das sich in der Abholposition eines Magazins befindliche Bauelement ein Schub, der von der jeweiligen Grösse der Bauelemente, vom jeweiligen Füllstand des Magazins und von der jeweiligen Einstellung der den Rütteltisch antreibenden Schwingvorrichtung abhängig ist. Andererseits können jedoch insbesondere kleinere elektronische Bauelemente durch schräge Bruchkanten, durch unterschiedlich ausfallende Zinnkuppen oder allgemein durch die bei einer Massenfertigung auftretenden Toleranzschwankungen eine derartige Geometrie aufweisen, die bei bestimmten Konstellationen zu einer vertikalen Schubkomponente und zu einem Aufstellen des sich in Abholposition eines Magazins befindlichen Bauelementes führen kann. Dieses durch Über- oder Untereinanderschieben der Bauelemente ausgelöste Aufstellen eines im Bereich der Entnahmeöffnung bereitgestellten Bauelementes kann selbst dann nicht mit der geforderten hohen Sicherheit ausgeschlossen werden, wenn die Amplitude der Schwingbewegung auf die jeweilige Grösse der Bauelemente und auf einen für die Förderung gerade noch ausreichenden Schub eingestellt wird. Ausserdem ist eine derartige Optimierung des Schwingverhaltens insbesondere bei kleinen Bauelementen als äusserst kritisch anzusehen. So kann beispielsweise bereits die Entfernung eines Magazins die schwingende Masse derart verändern, dass bei den verbleibenden Magazinen der Schub nicht mehr für die Förderung der Bauelemente ausreicht.

Der Erfindung liegt die Aufgabe zugrunde, einen Vibrationslängsförderer für das Zuführen von Bauelementen zu schaffen, bei welchem ein Aufstellen eines sich im Bereich der Entnahmeöffnung eines Magazins in Abholposition befindlichen Bauelementes mit absoluter Sicherheit ausgeschlossen werden kann.

Diese Aufgabe wird bei einem gattungsgemässen Vibrationslängsförderer durch die kennzeichnenden Merkmale des Anspruchs 1 gelöst.

Die mit der Erfindung erzielbaren Vorteile bestehen insbesondere darin, dass die Entnahmeöffnung eines Magazins während des Betriebes des Rütteltisches nach oben hin auf einfache Weise durch eine Abdeckung verschlossen wird und somit unabhängig von der jeweiligen Grösse der Bauelemente, unabhängig von dem jeweils eingestellten Schwingverhalten und unabhängig von dem jeweils wirkenden Schub ein Aufstellen der Bauelemente ausgeschlossen werden kann. Bei Stillstand des Rütteltisches kann dann die Entnahmeöffnung wieder freigegeben werden, da dann auf das sich in Abholposition befindliche Bauelement keine Schubkräfte mehr einwirken. Damit ist auf äusserst einfache Weise sichergestellt, dass der auf die Koordinaten der Abholposition programmierte Bestückkopf die Bauelemente dort auch stets in der richtigen Lage antrifft. Ein weiterer Vorteil ergibt sich dadurch, dass die Länge der Entnahmeöffnung eines Magazins nicht auf die Länge der jeweils zu fördernden Bauelemente abgestimmt werden muss und somit eine einzige Magazinform für die Förderung verschieden langer, aber im Querschnitt gleicher oder ähnlicher Bauelemente eingesetzt werden kann. Befinden sich im Bereich der Entnahmeöffnung dann mehrere kurze Bauelemente, so kann sich beim Betrieb des Rütteltisches keines dieser Bauelemente aufstellen, da dies durch die Abdeckung verhindert wird.

Nach einer bevorzugten Ausbildung der Erfindung ist vorgesehen, dass die Abdeckung an dem Unterbau angebracht ist und in ihrer ersten Stellung in geringem Abstand zu der Abflachung über der Entnahmeöffnung liegt. Dabei wird die Betätigung der Abdeckung durch die Anbringung an dem feststehenden Unterbau erleichtert, während durch den geringen Abstand zu der Abflachung eine Reibung zwischen Abdeckung und Abflachung und eine Dämpfung des Schwingverhaltens verhindert wird.

Gemäss einer weiteren Ausbildung der Erfindung ist die Abdeckung durch einen Schenkel eines L-förmigen Winkels gebildet, dessen anderer Schenkel an einem schwenkbaren Arm befestigt ist. Die erste und die zweite Stellung der Abdeckung können dann auf einfache Weise durch eine entsprechende Betätigung des schwenkbaren Armes eingenommen werden. Der schwenkbare Arm ist dabei vorzugsweise auf dem Unterbau gelagert, d.h. seine Betätigung wird durch die Anbringung an einem feststehenden Teil weiter erleichtert.

Bei einer weiteren bevorzugten Ausgestaltung der Erfindung ist der andere Schenkel des L-förmigen Winkels an dem schwenkbaren Arm in Längsrichtung verschiebbar befestigt. Der gewünschte Abstand zwischen der Abdeckung und der Abflachung eines Magazins kann dann leicht eingestellt werden.

An dem schwenkbaren Arm kann auch mindestens eine weitere Abdeckung befestigt sein. Hierdurch wird die Betätigung von verschiedenen Magazinen zugeordneten Abdeckungen erheblich vereinfacht. Dabei ist es zweckmässig, wenn die Abdeckungen an dem schwenkbaren Arm separat einstellbar befestigt sind und somit auch die Abstände zwischen den Abdeckungen und den zugeordneten Abflachungen der Magazine separat eingestellt werden können.

Bei einer weiteren bevorzugten Ausgestaltung des Vibrationslängsförderers ist die Abdeckung auf äusserst einfache Weise durch eine an dem schwenkbaren Arm befestigte Zuhaltungsfeder in ihrer ersten Stellung gehalten. Dabei liegt zweckmässigerweise der schwenkbare Arm in der ersten Stellung der Abdeckung an einem feststehenden Anschlag an.

Ist die Abdeckung gegen die Kraft der Zuhaltungsfeder durch ein an dem schwenkbaren Arm angreifendes Betätigungsglied in ihre zweite Stellung bringbar, so ergibt sich insgesamt nur ein geringer Aufwand für die Betätigung der Abdeckung. Als Betätigungsglied ist dabei insbesondere ein magnetisch oder pneumatisch betätigbarer Hubzylinder geeignet.

Da für den erfindungsgemässen Vibrationslängsförderer keine einstellbaren Bauelemente-Anschläge benötigt werden, ist der Bauelemente-Anschlag vorzugsweise leistenförmig ausgebildet und unmittelbar vor dem vorderen Magazinende an dem Rütteltisch befestigt. Hierbei wird durch den geringen Platzbedarf eines derartigen Bauelement-Anschlags die Betätigung der Abdeckung und ihre Anbringung am Unterbau erleichtert.

Ein Ausführungsbeispiel der Erfindung ist in der Zeichnung dargestellt und wird im folgenden näher beschrieben. Es zeigen:

Fig. 1 eine Seitenansicht eines Vibrationslängsförderers,

Fig. 2 eine perspektivische Ansicht eines Magazins im Bereich der Entnahmeöffnung,

Fig. 3 eine stirnseitige Ansicht des in Fig. 1 dargestellten Vibrationslängsförderers und

Fig. 4 eine Draufsicht auf den in Fig. 1 dargestellten Vibrationslängsförderer.

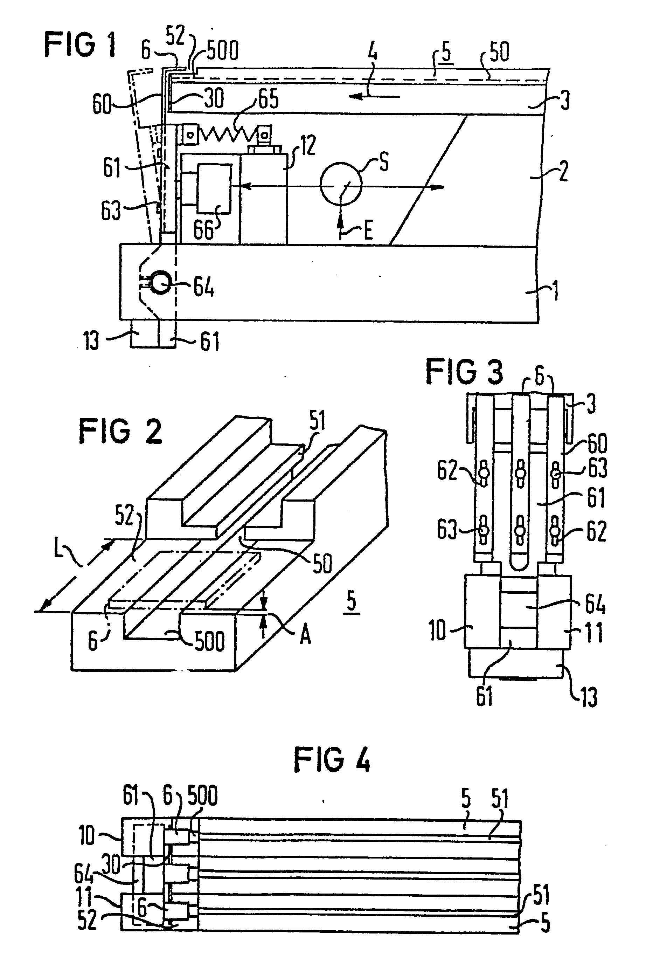

Die Figuren 1, 3 und 4 zeigen in stark vereinfachter schematischer Darstellung den vorderen Zuführbereich eines Vibrationslängsförderers. Dabei ist auf einem feststehenden Unterbau 1 eine in der Zeichnung nur angedeutete elektromechanische Schwingvorrichtung 2 angeordnet, über welche ein darüberliegender Rütteltisch 3 angetrieben werden kann, wobei die Förderrichtung des Rütteltisch 3 durch einen Pfeil 4 angedeutet ist. Auf dem Rütteltisch 3 sind in dem dargestellten Ausführungsbeispiel drei Magazine 5 nebeneinander angeordnet.

Fig. 2 zeigt in perspektivischer Darstellung das vordere Magazinende eines dieser Magazine 5. Das aus einem stranggepressten Profil bestehende Magazin 5 besitzt eine in Längsrichtung verlaufende Bauelemente-Aufnahmenut 50, deren Querschnitt dem Querschnitt der zu fördernden Bauelemente angepasst ist. Die im Querschnitt rechteckförmig ausgebildete Bauelemente-Aufnahmenut 50 ist nach oben hin durch einen in Längsrichtung verlaufenden Schlitz 51 geöffnet, wobei die Breite dieses Schlitzes 51 jedoch derart eng bemessen ist, dass sich die in der Bauelemente-Aufnahmenut 50 befindlichen elektronischen Bauelemente nicht aufstellen können. Am vorderen Magazinende ist durch Fräsen eine Abflachung 52 hergestellt, in deren Bereich die Bauelemente-Aufnahmenut 50 eine nach oben hin U-förmig geöffnete Entnahmeöffnung 500 für die elektronischen Bauelemente bildet. Die mit L bezeichnete Länge der Entnahmeöffnung 500 ist dabei so bemessen, dass auch die längsten der mit dem Magazin 5 zuzuführenden elektronischen Bauelemente mit Hilfe eines Bestückkopfes ungehindert nach oben hin entnommen werden können. Der Entnahmeöffnung 500 ist eine in Fig. 2 durch strichpunktierte Linien angedeutete plattenförmige Abdeckung 6 zugeordnet, welche beweglich ist und zeitweilig in einer ersten Stellung in geringem Abstand A von beispielsweise 0,1 mm über der Abflachung 52 liegt.

Zur Erläuterung der Wirkungsweise der jeweils einem Magazin 5 zugeordneten Abdeckungen 6 wird wieder auf die Figuren 1, 3 und 4 verwiesen. Es ist zu erkennen, dass jede Abdeckung 6 durch einen Schenkel eines L-förmigen Winkels gebildet ist. Die anderen Schenkel 60 der L-förmigen Winkel sind an einem gemeinsamen schwenkbaren Arm 61 befestigt. Diese Befestigung erfolgt jeweils über Langlöcher 62 der Schenkel 60 und über in dem schwenkbaren Arm 61 verankerte Schrauben 63, so dass die Abstände A (vgl. Fig. 2) zwischen den Abflachungen 52 und den Abdeckungen 6 jeweils separat eingestellt werden können. Der schwenkbare Arm 61 ist zwischen zwei stirnseitig vorspringenden Wangen 10 und 11 des Unterbaus 1 auf einem Bolzen 64 drehbar gelagert, wobei der Bolzen 64 beiderseits in den Wangen 10 und 11 befestigt ist. Während des Betriebes des Rütteltisches 3 nehmen die Abdeckungen 6 die in der Zeichnung dargestellte erste Stellung ein, in welcher sie die zugeordneten Entnahmeöffnungen 500 verschliessen. Diese erste Stellung wird durch eine Zuhaltungsfeder 65 herbeigeführt, welche einerseits an dem schwenkbaren Arm 61 und andererseits an einer mit dem Unterbau 1 fest verbundenen Halterung 12 befestigt ist. Dabei ist zur Begrenzung der ersten Stellung ein an dem Unterbau 1 angebrachter Anschlag 13 vorgesehen, an welchem ein über den Bolzen 64 hinausragender Teil des schwenkbaren Armes 61 anliegt. Durch diese Lagebegrenzung wird verhindert, dass die Zuhaltungsfeder 65 die Schenkel 60 der L-förmigen Winkel gegen einen unmittelbar vor dem Magazinende angeordneten und an der Stirnseite des Rütteltisches 3 befestigten, leistenförmig ausgebildeten Bauelemente-Anschlag 30 drückt.

Bei der in der Zeichnung dargestellten ersten Stellung der Abdeckungen 6 wird verhindert, dass sich während des Betriebes des Rütteltisches 3 die im Bereich der Entnahmeöffnungen 500 befindlichen und an dem Bauelemente-Anschlag 30 anliegenden elektronischen Bauelemente aufstellen können. Sobald der Rütteltisch 3 stillsteht, wird auf die elektronischen Bauelemente kein Schub mehr ausgeübt und die Gefahr des Aufstellens der in Abholposition bereitgestellten elektronischen Bauelemente entfällt. Die Abdeckungen 6 werden dann durch eine entsprechende Auslenkung des schwenkbaren Armes 61 in eine zweite Stellung gebracht, in welcher die Entnahmeöffnungen 500 nicht mehr verschlossen sind und die in Abholposition bereitgestellten elektronischen Bauelemente durch einen Bestückkopf nach oben entnommen werden können. Diese zweite Stellung der Abdeckungen 6 und des schwenkbaren Armes 61 ist in Fig. 1 durch strichpunktierte Linien angedeutet. Damit nun der schwenkbare Arm 61 bei Stillstand des Rütteltisches 3 in die zweite Stellung gebracht werden kann, ist ein gegen die Kraft der Zuhaltungsfeder 65 wirkendes und an den schwenkbaren Arm 61 angreifendes Betätigungsglied 66 vorgesehen. Dieses an der Halterung 12 angebrachte Betätigungsglied 66 ist im dargestellten Ausführungsbeispiel als magnetischer Hubzylinder ausgebildet.

Wie bereits erwähnt wurde, dürfen die Entnahmeöffnungen 500 der Magazine 5 nur dann freigegeben werden, wenn der Rütteltisch 3 stillsteht. Dies ist in Fig. 1 symbolisch durch einen Schalter S dargestellt. Dieser Schalter S hat die Funktion eines Entweder-Oder-Gliedes, welches ein durch einen Pfeil E angedeutetes Einschaltsignal entweder der elektromechanischen Schwingvorrichtung 2 oder dem Betätigungsglied 66 zuführt. Das Einschaltsignal für das Betätigungsglied 66 könnte beispielsweise aber auch von einem Bestückkopf abgeleitet werden, der ja nur bei Stillstand des Rütteltisches 3 die Abholposition der elektronischen Bauelemente anfährt.

## Patentansprüche

1. Vibrationslängsförderer für das Zuführen von Bauelementen, mit
- einem auf einem Unterbau (1) angeordneten und durch eine Schwingvorrichtung (2) antreibbaren Rütteltisch (3),
- mindestens einem auf dem Rütteltisch angeordneten Magazin (5),
- einer am vorderen Magazinende durch eine Abflachung (52) gebildeten Entnahmeöffnung (500) und mit
- einem dem vorderen Magazinende zugeordneten Bauelementeanschlag (30),
gekennzeichnet durch folgende Merkmale:
a) der Entnahmeöffnung (500) ist eine bewegliche Abdeckung (6) zugeordnet, welche
b) in einer ersten Stellung während des Betriebes des Rütteltisches (3) die Entnahmeöffnung (500) nach oben hin verschliesst und
c) in einer zweiten Stellung bei Stillstand des Rütteltisches (3) die Entnahmeöffnung (500) freigibt.

2. Vibrationslängsförderer nach Anspruch 1, dadurch gekennzeichnet, dass die Abdeckung (6) an dem Unterbau (1) angebracht ist und in ihrer ersten Stellung in geringem Abstand (A) zu der Abflachung (52) über der Entnahmeöffnung (500) liegt.

3. Vibrationslängsförderer nach Anspruch 1, dadurch gekennzeichnet, dass die Abdeckung (6) durch einen Schenkel eines L-förmigen Winkels gebildet ist, dessen anderer Schenkel (60) an einem schwenkbaren Arm (61) befestigt ist.

4. Vibrationslängsförderer nach Anspruch 2 und 3, dadurch gekennzeichnet, dass der schwenkbare Arm (61) auf dem Unterbau (1) gelagert ist.

5. Vibrationslängsförderer nach Anspruch 3 oder 4, dadurch gekennzeichnet, dass der andere Schenkel (60) des L-förmigen Winkels an dem schwenkbaren Arm (61) in Längsrichtung verschiebbar befestigt ist.

6. Vibrationslängsförderer nach einem der Ansprüche 3 bis 5, dadurch gekennzeichnet, dass an dem schwenkbaren Arm (61) mindestens eine weitere Abdeckung (6) befestigt ist.

7. Vibrationslängsförderer nach Anspruch 5 und 6, dadurch gekennzeichnet, dass die Abdeckungen (6) an dem schwenkbaren Arm (61) separat einstellbar befestigt sind.

8. Vibrationslängsförderer nach einem der Ansprüche 3 bis 7, dadurch gekennzeichnet, dass die Abdeckung (6) durch eine an dem schwenkbaren Arm (61) befestigte Zuhaltungsfeder (65) in ihrer ersten Stellung gehalten ist.

9. Vibrationslängsförderer nach Anspruch 8, dadurch gekennzeichnet, dass in der ersten Stellung der Abdeckung (6) der schwenkbare Arm (61) an einem feststehenden Anschlag (13) anliegt.

10. Vibrationslängsförderer nach Anspruch 8 oder 9, dadurch gekennzeichnet, dass die Abdeckung (6) gegen die Kraft der Zuhaltungsfeder (65) durch ein an dem schwenkbaren Arm (61) angreifendes Betätigungsglied (66) in ihre zweite Stellung bringbar ist.

11. Vibrationslängsförderer nach Anspruch 10, dadurch gekennzeichnet, dass als Betätigungsglied (66) ein magnetisch oder pneumatisch betätigbarer Hubzylinder vorgesehen ist.

12. Vibrationslängsförderer nach einem der vorhergehenden Ansprüche, dadurch gekennzeichnet, dass der Bauelemente-Anschlag (30) leistenförmig ausgebildet und unmittelbar vor dem vorderen Magazinende an dem Rütteltisch (3) befestigt ist.

## Claims

1. A linear vibratory conveyor for supplying components, comprising
- a jolting table (3) which is arranged on a base (1) and can be driven by a swivel device (2),
- at least one magazine (5) which is arranged on the jolting table,
- an extraction opening (500) which is formed by a flat section (52) at the front magazine end and comprising
- a component stop (30) associated with the front magazine end,
characterised by the following features:
a) a movable cover (6) is associated with the extraction opening (500), which cover
b) seals the extraction opening (500) in a first position during the operation of the jolting table (3) upwardly and
c) opens the extraction opening (500) in a second position during the standstill of the jolting table (3).

2. A linear vibratory conveyor as claimed in claim 1, characterised in that the cover (6) is fixed to the base (1) and in its first position lies above the extraction opening (500) at a negligible distance (A) from the flat section (52).

3. A linear vibratory conveyor as claimed in claim 1, characterised in that the cover (6) is formed by a flank of an L-shaped angle, whose other flank (60) is secured to a pivotable arm (61).

4. A linear vibratory conveyor as claimed in claim 2 and 3, characterised in that the pivotable arm (61) is positioned on the base (1).

5. A linear vibratory conveyor as claimed in claim 3 or 4, characterised in that the other flank (60) of the L-shaped angle is longitudinally displaceably secured to the pivotable arm (61).

6. A linear vibratory conveyor as claimed in one of claims 3 to 5, characterised in that at least one further cover (6) is secured to the pivotable arm (61).

7. A linear vibratory conveyor as claimed in one of claims 5 and 6, characterised in that the covers (6) are secured to the pivotable arm (61) so as to be separately adjustable.

8. A linear vibratory conveyor as claimed in one of claims 3 to 7, characterised in that the cover (6) is retained in its first position by a retaining spring (65) which is secured to the pivotable arm (61).

9. A linear vibratory conveyor as claimed in claim 8, characterised in that in the first position of the cover (6) the pivotable arm (61) abuts a stationary stop (13).

10. A linear vibratory conveyor as claimed in claim 8 or 9, characterised in that the cover (6) can be brought into its second position by an actuating element (66), which acts upon the pivotable arm (61), against the force of the retaining spring (65).

11. A linear vibratory conveyor as claimed in claim 10, characterised in that a magnetically or pneumatically operable lifting cylinder is arranged as an actuating element (66).

2. A linear vibratory conveyor as claimed in one of the preceding claims, characterised in that the component stop (30) is strip-shaped and is secured to the jolting table (3) directly preceding the front magazine end.

**Revendications**

1. Transporteur longitudinal à vibrations pour l'amenée de composants, comportant
- une table à secousses (3) montée sur une embase (1) et susceptible d'être entraînée par un dispositif oscillant (2),
- au moins un magasin (5) disposé sur la table à secousses,
- une ouverture de prélèvement (500) formée par un méplat (52) à l'extrémité antérieure du magasin, et avec
- une butée (30) pour les composants associée à l'extrémité antérieure du magasin,
caractérisé par les moyens suivants:
a) à l'ouverture de prélèvement (500) est associé un obturateur mobile (6) lequel

b) dans une première position, pendant le fonctionnement de la table à secousses (3), obture l'ouverture de prélèvement (500) vers le haut, et
c) dans une seconde position, à l'arrêt de la table à secousses (3), dégage l'ouverture de prélèvement (500).

2. Transporteur longitudinal à vibrations selon la revendication 1, caractérisé par le fait que l'obturateur (6) est monté sur l'embase (1) et il se situe, dans sa première position, à sa plus faible distance (A) par rapport au méplat (52), au-dessus de l'ouverture de prélèvement (500).

3. Transporteur longitudinal à vibrations selon la revendication 1, caractérisé par le fait que l'obturateur est formé par une branche d'une pièce coudée en L, dont l'autre branche (60) est fixée à un bras basculant (61).

4. Transporteur longitudinal à vibrations selon les revendications 2 et 3, caractérisé par le fait que le bras basculant (61) est articulé sur l'embase (1).

5. Transporteur longitudinal à vibrations selon la revendication 3 ou 4, caractérisé par le fait que l'autre branche (60) de la pièce en forme de L est fixée au bras basculant (61) de manière à pouvoir être déplacée dans la direction longitudinale.

6. Transporteur longitudinal à vibrations selon l'une des revendications 3 à 5, caractérisé par le fait qu'au bras basculant (61) est fixée au moins un second obturateur (6).

7. Transporteur longitudinal à vibrations selon les revendications 5 et 6, caractérisé par le fait que les obturateurs (6) sont fixés au bras basculant (61) de façon à pouvoir être ajustés séparément.

8. Transporteur longitudinal à vibrations selon l'une des revendications 3 à 7, caractérisé par le fait que l'obturateur (6) est maintenu dans sa première position par un ressort de fermeture (65) et qui est fixé au bras basculant (61).

9. Transporteur longitudinal à vibrations selon la revendication 8, caractérisé par le fait que dans la première position de l'obturateur (6), le bras basculant (61) porte contre une butée fixe (13).

10. Transporteur longitudinal à vibrations selon la revendication 8 ou 9, caractérisé par le fait que l'obturateur (6) est susceptible d'être amené dans sa seconde position, et à l'encontre de la force du ressort de fermeture (65), par un organe de commande (66) qui attaque le bras basculant (61).

11. Transporteur longitudinal à vibrations selon la revendication 10, caractérisé par le fait qu'il est prévu, en tant qu'organe de commande (66), un cylindre de levage qui est susceptible d'être commandé par voie magnétique ou pneumatique.

12. Transporteur longitudinal à vibrations selon l'une des revendications précédentes, caractérisé par le fait que la butée (30) pour les composants a la forme d'une réglette et est fixée à la table à secousses (3), directement devant l'extrémité antérieure du magasin.

# FIG 1

# FIG 2

# FIG 3

# FIG 4